# EUROPEAN PATENT SPECIFICATION

(11) **EP 1 693 895 B1**
(45) Date of publication and mention of the grant of the patent: **13.03.2013**
(21) Application number: 04819316.3
(22) Date of filing: 17.11.2004
(51) Int. Cl.: H01L 29/16, H01L 29/66, H01J 1/30

(54) **DIAMOND n-TYPE SEMICONDUCTOR, MANUFACTURING METHOD THEREOF, SEMICONDUCTOR ELEMENT, AND ELECTRON EMITTING ELEMENT**
HALBLEITER DES DIAMANT-N-TYPS, HERSTELLUNGSVERFAHREN DAFÜR, HALBLEITERELEMENT UND ELEKTRONENEMISSIONSELEMENT
SEMI-CONDUCTEUR DE DIAMANT DE TYPE N, PROCEDE DE FABRICATION, ELEMENT SEMI-CONDUCTEUR, ET ELEMENT EMETTEUR D'ELECTRONS

(30) Priority: 25.11.2003 JP 2003394183; 24.03.2004 JP 2004087812
(43) Date of publication of application: 23.08.2006
(73) Proprietor: Sumitomo Electric Industries, Ltd., Osaka-shi, Osaka 541-0041 (JP)
(72) Inventor: NAMBA, Akihiko, c/o Itami Works, Itami-shi, Hyogo 664-0016 (JP); NISHIBAYASHI, Yoshiki, c/o Itami Works, Itami-shi, Hyogo 664-0016 (JP); IMAI, Takahiro, c/o Itami Works, Itami-shi, Hyogo 664-0016 (JP)
(74) Representative: Cross, Rupert Edward Blount
(86) International application number: PCT/JP2004/017077
(87) International publication number: WO 2005/053029

(56) References cited:
- WO-A1-00/58534
- JP-A- 1 068 966
- JP-A- 4 238 895
- JP-A- 4 352 365
- JP-A- 6 021 084
- JP-A- 10 189 939
- JP-A- 2001 068 687
- JP-A- 2003 303 954
- US-A- 5 280 185
- US-A1- 2002 127 405

## Description

### Technical Field

The present invention relates to a diamond n-type semiconductor, a method of manufacturing the same, a semiconductor device employing the diamond n-type semiconductor, and an electron emitting device employing the diamond n-type semiconductor.

### Background Art

Power devices such as SCR, GTO, SIT, IGBT, and MISFET employing semiconductor materials have been manufactured while using n- and p-type semiconductors. It is important for these power devices to not only control their carrier concentrations, but also form a very high carrier concentration and lower their resistance. This is because their contact resistance to electrode metals for supplying a current is preferably as low as possible. Therefore, n⁺ and p⁺ layers have conventionally been formed by high-concentration doping, so as to realize an ohmic characteristic with a low resistance to metal layers through thus formed layers. The n⁺ and p⁺ layers may be formed by epitaxial growth or by forming a metal or the like and dispersing elements by annealing. They may also be formed by ion implantation. However, there are many wide-gap materials which cannot realize low-resistance n- and p-type layers. In this case, low contact resistance cannot be realized.

The low-resistance n-type layers not only determine characteristics of semiconductors, but also greatly affect electron emitting devices employable in displays, electron guns, fluorescent tubes, and vacuum tubes. In particular, they tend to lower the electron affinity in wide-gap materials, so that materials having a smaller work function can be obtained when formed with an n-type layer, which are hopeful as an electron emitting material. If their carrier concentration is low, however, electrons cannot fully be accumulated even when biased, so that the bias applying effect cannot be utilized effectively, whereby electron emissions cannot be made easier.

As in the foregoing, semiconductors having a high carrier concentration (electron concentration in particular) are important when employed for either semiconductors or electron emissions.

In diamond, high-concentration doping of n-type semiconductors has been difficult, while very-high-concentration doping of p-type semiconductors has been easy. Though low-concentration n-type semiconductors can be realized by P (phosphorus) doping or S (sulfur) doping, it has been very difficult to raise the doping concentration thereof. Namely, these elements are greater than C (carbon) which is an atom constituting diamond, and are harder to be incorporated at the time of crystal growth. Even when high-concentration doping is achieved, the crystallinity of diamond is expected to break down greatly, thereby raising the resistance on the contrary. Even when the crystallinity is kept, defects may occur. In this case, mobility is expected to decrease, thereby raising the resistance as well. High-concentration doping by ion implantation has been tried, but failed since the crystallinity has been very hard to restore because of irradiation damages caused by a high dosage of ion implantation.

In such a case, it is even uncertain whether the resulting diamond semiconductor is of n-type or not. When diamond breaks down its crystallinity or incurs a defect, however, a pi bond may occur in carbon, thereby yielding metallic conduction even at a low resistance. Therefore, it is important to determine whether the diamond semiconductor is of n-type or not and verify that the diamond semiconductor is of n-type. Metallic conduction in a crystal is not so important, since this means a greater work function. On the other hand, n-type indicates that carriers are conducted in an area sufficiently close to a conduction band, which makes diamond important as a semiconductor device and an electron emitting device.

Known as examples of conventional diamond semiconductors are those disclosed in Patent Documents 1 to 3 and Non-patent Documents 1 to 4. Patent Documents 1 and 2 disclose diamond semiconductors in which diamond substrates are combined with P- and S-doped films, respectively, in a vapor phase. Patent Document 1 and Non-patent Document 1 disclose diamond semiconductors doped with large amounts of N (nitrogen) and B (boron) as n- and p-type dopants, respectively. Each of Non-patent Documents 2 and 3 discloses the combining of a diamond {111} substrate with a P-doped film in a vapor phase. Non-patent Document 4 discloses the combining of a diamond {100} substrate with an S-doped film in a vapor phase.

US 2002/0127405 discloses a N-doped diamond semiconductor layer.
Patent Document 1: Japanese Patent Publication No. 1704860
Patent Document 2: Japanese Patent Publication No. 2081494
Patent Document 3: Japanese Patent Publication No. 3374866
Non-patent Document 1: Shiomi et al., JJAP, Vol. 30 (1991), p. 13 63
Non-patent Document 2: Teraji et al., New Diamond, Vol. 17, No. 1 (2001), p. 6
Non-patent Document 3: Koizumi et al., Appl. Phys. Lett., Vol. 71, No. 8 (1997), p. 1065
Non-patent Document 4: Gamo et al., New Diamond, Vol. 15, No. 4 (1999), p. 20

### Disclosure of the Invention

### Problem to be Solved by the Invention

The inventors studied conventional diamond n-type semiconductors in detail and, as a result, have found the following problem. Namely, the conventional diamond n-type semiconductors have a low carrier concentration at room temperature, while the amount of change in carrier concentration is very large in a temperature region from room temperature to a high temperature. Consequently, the amount of change in resistance value is very large. In diamond doped with P, for example, the carrier concentration is usually on the order of 10¹³ cm⁻³ to 10¹⁴ cm⁻³ at room temperature and on the order of 10¹⁷ cm⁻³ to 10¹⁸ cm⁻³ at a high temperature of 500°C. When applying the diamond n-type semiconductors to semiconductor devices and electron emitting devices, such a characteristically large change in carrier concentration caused by temperatures prevents these devices from favorably operating in a wide temperature range. In other words, the diamond n-type semiconductors having such a characteristic are remarkably restricted in terms of their applicability to various devices.

For solving the problem mentioned above, it is an object of the present invention to provide a diamond n-type semiconductor in which the amount of change in carrier concentration is fully reduced in a wide temperature range, a method of manufacturing the same, a semiconductor device employing the diamond n-type semiconductor, and an electron emitting device employing the diamond n-type semiconductor.

### Means for Solving Problem

For solving the above-mentioned problem, the diamond n-type semiconductor according to the present invention comprises a first diamond semiconductor having n-type conduction. In this diamond semiconductor, a conductor exhibits an electron concentration negatively correlated with temperature in a temperature range of at least 100°C within at least the temperature region from 0°C to 300°C.

In the diamond n-type semiconductor according to the present invention, there is a temperature region in which the electron concentration, i.e., carrier concentration, of a conductor is negatively correlated with temperature. Here, the carrier concentration negatively correlated with temperature means that the carrier concentration becomes lower as the temperature is higher. Since the carrier concentration is negatively correlated with temperature over a temperature range of at least 100°C within at least the temperature region from 0°C to 300°C, the amount of change in carrier concentration in a wide temperature range is smaller than that in the conventional diamond n-type semiconductors whose carrier concentration is always positively correlated with temperature. The negative correlation appearing in the temperature region from 0°C to 300°C is very useful in terms of applications of the diamond n-type semiconductor. This is because the above-mentioned temperature region is typically included in temperatures at which semiconductor devices and electron emitting devices are used. Therefore, the diamond n-type semiconductor according to the present invention can widely be applied to various semiconductor devices and electron emitting devices. Here, the amount of change in carrier concentration refers to the difference between the maximum and minimum values of carrier concentration in a given temperature range. Specifically, the amount of change in carrier concentration in the temperature range from 0°C to 500°C is less than 3 digits, more preferably less than 1 digit.

Preferably, in the first diamond semiconductor, the conductor exhibits a Hall coefficient positively correlated with temperature in a temperature range of at least 100°C within at least the temperature region from 0°C to 300°C. In the diamond n-type semiconductor according to the present invention, the Hall coefficient of the conductor is proportional to the reciprocal of the electron concentration, i.e., carrier concentration. Namely, the Hall coefficient of the conductor is positively correlated with temperature when the carrier concentration of electrons is negatively correlated with temperature. When the Hall coefficient of the conductor is positively correlated with temperature over a temperature range of at least 100°C within at least the temperature region from 0°C to 300°C, the amount of change in Hall coefficient in a wide temperature range is smaller than that in the conventional diamond n-type semiconductors in which the conductor always exhibits a Hall coefficient negatively correlated with temperature. Here, the amount of change in Hall coefficient refers to the difference between the maximum and minimum values of Hall coefficient in a given temperature range. Specifically, the amount of change in Hall coefficient in the temperature range from 0°C to 500°C is preferably less than 3 digits, more preferably less than 1 digit.

When a multilayer structure with an n-type layer having a donor element concentration lower than that of the first diamond semiconductor is formed by using the first diamond semiconductor, a higher carrier leaking effect from the first diamond semiconductor to the n-type layer is obtained.

In particular, it will be preferred if the temperature range exists over at least 200°C within the temperature region from 0°C to 300°C. When the carrier concentration is negatively correlated with temperature over such a temperature range of 200°C or more while the Hall coefficient of the conductor is positively correlated with temperature, the amount of change in carrier concentration in a wide temperature range becomes sufficiently small.

Preferably, the first diamond semiconductor has a resistivity of 500 Ωcm or less at least at a temperature within the temperature region from 0°C to 300°C. When this diamond n-type semiconductor is employed in a semiconductor device or electron emitting device, its contact resistance to an electrode metal which supplies a current to the device becomes smaller, since a sufficiently low resistivity of 500 Ωcm is exhibited in a temperature region in which the Hall coefficient is positively correlated with temperature while the carrier concentration is negatively correlated with temperature.

Preferably, the electron concentration of the first diamond semiconductor is always at least 10¹⁶ cm⁻³ in the temperature region from 0°C to 300°C. When this diamond n-type semiconductor is employed in an electron emitting device, its bias applying effect becomes remarkable, since the electron concentration is always at least 10¹⁶ cm⁻³ in a temperature region in which the Hall coefficient is positively correlated with temperature while the carrier concentration is negatively correlated with temperature, i.e., the minimum value of carrier concentration in this temperature region is at least 10¹⁶ cm⁻³, or the maximum value of Hall coefficient is 6.25 x 10² C⁻¹cm³ in this temperature region, whereby a favorable electron emission characteristic is obtained.

The first diamond semiconductor contains more than 5 x 10¹⁹ cm⁻³ in total of at least one kind of donor element. Doping with at least one kind of donor element by a total amount of more than 5 x 10¹⁹ cm⁻³ can favorably manufacture a diamond n-type semiconductor having a sufficiently high carrier concentration. When growing diamond in a vapor phase, a hydrogen gas and a gas containing carbon are introduced as materials into a synthesizing apparatus (chamber) which is held at a pressure on the order of 1.33 x 10³ Pa to 1.33 x 10⁴ Pa, and high energy is applied to them, so as to generate active species such as radicals and ions including those of hydrogen and carbon, and diamond is grown such that the sp³ bond of carbon is always kept on a substrate. The temperature in the surroundings of the substrate at the time of growth is at least 600°C, while gas flows in the chamber are designed such that the active species efficiently reach the substrate surface. However, high-concentration doping is difficult even when a doping gas containing a donor element is similarly introduced into such an apparatus. This is because such gases begin to decompose at a temperature lower than 600°C, so that only a very small amount of donor elements are transported onto the substrate, whereas the rest adhere to chamber walls or are let out of the chamber. Such a loss is detrimental to high-concentration doping in the case of donor elements having a low doping efficiency because of their large atomic radius. The inventors conducted diligent studies and, as a result, have manufactured diamond containing more than 5 x 10¹⁹ cm⁻³ in total of at least one kind of donor element by optimizing the doping gas introduction, e.g., by supplying the doping gas into the chamber from a gas inlet provided at a substrate support table such that the position for introducing the doping gas into the chamber is placed very close to the substrate, keeping the piping cooler than a temperature where the doping gas decomposes, and so forth, in order for the donor element to reach the substrate by a large amount while growing diamond on the substrate.

The donor element is an element containing at least P. By thus containing at least P as a donor element, the first diamond semiconductor further remarkably exhibits the above-mentioned effect of being able to favorably manufacture a diamond n-type semiconductor having a sufficiently high carrier concentration.

The first diamond semiconductor contains an impurity element other than the donor element together with the donor element. Thus doping with the donor element while introducing an impurity element other than the donor element is effective in enabling very-high-concentration doping with the donor element while keeping the crystallinity of diamond from deteriorating.

The first diamond semiconductor contains at least 1 x 10¹⁷ cm⁻³ of Si as the impurity element. By thus containing at least 1 x 10¹⁷ cm⁻³ of Si as the impurity element, the first diamond semiconductor further remarkably exhibits the above-mentioned effect of enabling very-high-concentration doping with the donor element while keeping the crystallinity of diamond from deteriorating. This effect appears at a P/C (ratio between the number of phosphorus atoms and the number of carbon atoms) of at least 5,000 ppm in a vapor phase when making a P-doped diamond semiconductor by vapor-phase growth.

Preferably, the first diamond semiconductor is monocrystal diamond. This yields a diamond n-type semiconductor having a particularly excellent characteristic as an n-type semiconductor in comparison with the case with polycrystal diamond.

The diamond n-type semiconductor according to the present invention may further comprise a second diamond semiconductor provided adjacent to the first diamond semiconductor and turned out to be n-type. Preferably, in the second diamond semiconductor, a conductor exhibits an electron concentration not negatively correlated with temperature and a Hall coefficient not positively correlated with temperature. In this case, carriers leak (disperse) from the first diamond semiconductor into the second diamond semiconductor adjacent thereto, thereby increasing the carrier concentration of the whole diamond n-type semiconductor comprising the first and second diamond semiconductors. The present invention yields a particularly strong carrier leaking effect, since the carrier concentration of a diamond semiconductor is negatively correlated with temperature while the Hall coefficient of the conductor is positively correlated with temperature as mentioned above. Here, the first and second diamond semiconductors are those having characteristics different from each other. For example, the second diamond semiconductor is a conventional diamond semiconductor.

The semiconductor device according to the present invention is at least partly constituted by the diamond n-type semiconductor having the structure mentioned above (the diamond n-type semiconductor according to the present invention). This yields a semiconductor device which can favorably operate in a wide temperature range. The diamond n-type semiconductor is employable in a contact part with respect to an electrode metal in a semiconductor device, for example. This realizes favorable ohmic contact.

In the electron emitting device according to the present invention, at least an electron emitting part is constituted by a diamond n-type semiconductor having the structure mentioned above (the diamond n-type semiconductor according to the present invention). This yields an electron emitting device which operates favorably over a wide temperature range. This also makes it possible to realize an electron emitting device having a high electron emitting property.

The method of manufacturing a diamond n-type semiconductor according to the present invention comprises the step of epitaxially growing the first diamond semiconductor on a diamond substrate while artificially introducing an impurity element other than a donor element to the diamond substrate. This can yield a diamond n-type semiconductor doped with a large amount of the donor element while preventing the crystallinity of diamond from deteriorating greatly. Here, artificially introducing the impurity element is meant to exclude cases where impurities other than the donor element mingle naturally or accidentally. By forming the first diamond semiconductor while artificially introducing a distortion or defect into a crystal, this manufacturing method can also yield a diamond n-type semiconductor doped with a large amount of the donor element.

The impurity element introduced to the diamond substrate in the method of manufacturing a diamond n-type semiconductor according to the present invention is preferably Si. When Si is used as the impurity, the above-mentioned effect of yielding a diamond n-type semiconductor doped with a large amount of the donor element while preventing the crystallinity of diamond from greatly deteriorating is exhibited further remarkably.

Such techniques of artificially introducing an impurity element other than the donor element and artificially providing a crystal distortion or crystal defect contradict the aimed direction of the prior art for ameliorating the crystallinity of diamond by raising its purity, and are discoveries obtained as a result of diligent studies by the inventors. Even when the prior art enables high-concentration doping with P or S as a donor element, such an element is greater than carbon which is a constituent atom of diamond, so that crystal lattices may be distorted, thus deteriorating the crystallinity. When the crystallinity of diamond breaks down or a defect is introduced into a crystal, its electric resistance may rise. Though the electric resistance may decrease when the introduced defect graphitically includes a pi bond, its conductivity is metallic, so that it is not turned out to be n-type by measurement/evaluation.

For making a state which is turned out to be n-type and allows electricity to flow, it will be sufficient if a conductive level is formed near a donor level without breaking down the crystallinity of diamond even when doped with a large amount of P or S. In this case, a point defect or the like is introduced into the crystal, so that electric conduction is possible by mechanisms such as hopping and other defect bands at an in-gap level. The inventors have obtained a discovery that such a conduction mechanism can be realized in a very simple manner when doping with a donor element is performed while introducing an impurity other than the donor element or providing a crystal distortion or crystal defect as mentioned above.

The present invention will be more fully understood from the detailed description given hereinbelow and the accompanying drawings, which are given by way of illustration only and are not to be considered as limiting the present invention.

Further scope of applicability of the present invention will become apparent from the detailed description given hereinafter.

### Effect of the Invention

The present invention realizes a diamond n-type semiconductor in which the amount of change in carrier concentration is fully reduced in a wide temperature range, a method of manufacturing the same, and a semiconductor device and electron emitting device using the diamond n-type semiconductor.

### Brief Description of the Drawings

Fig. 1 is a sectional view showing the structure of a typical embodiment of the diamond n-type semiconductor according to the present invention;
Fig. 2 is a view for explaining a carrier leaking effect;
Fig. 3 is a graph showing measurement results concerning the temperature dependency of carrier concentration in a sample manufactured as the diamond n-type semiconductor according to the present invention;
Fig. 4 is a graph showing measurement results concerning the temperature dependency of Hall coefficient in the sample manufactured as the diamond n-type semiconductor according to the present invention;
Fig. 5 is a graph showing measurement results concerning the temperature dependency of resistivity in the sample manufactured as the diamond n-type semiconductor according to the present invention;
Fig. 6 is a photograph showing an electron emitting part in an electron emitting device employing the diamond n-type semiconductor according to the present invention;
Fig. 7 is a table showing conditions under which phosphorus-doped layers were synthesized and measurement results of the Hall effect in a plurality of samples manufactured as diamond n-type semiconductors according to the present invention;
Fig. 8 is a table showing conditions under which phosphorus-doped layers were synthesized when Si was supplied by a gas, Si atom concentrations in SIMS results, and measurement results of Hall effect in a plurality of samples manufactured as diamond n-type semiconductors according to the present invention; and
Fig. 9 is a table showing conditions under which phosphorus-doped layers were synthesized when Si was supplied by a solid, Si atom concentrations in SIMS results, and measurement results of Hall effect in a plurality of samples manufactured as diamond n-type semiconductors according to the present invention.

### Description of the Reference Numerals

1, 2···diamond n-type semiconductor; 10···diamond substrate; 12···first diamond semiconductor layer; and 14a, 14b··· second diamond semiconductor layer.

### Best Modes for Carrying Out the Invention

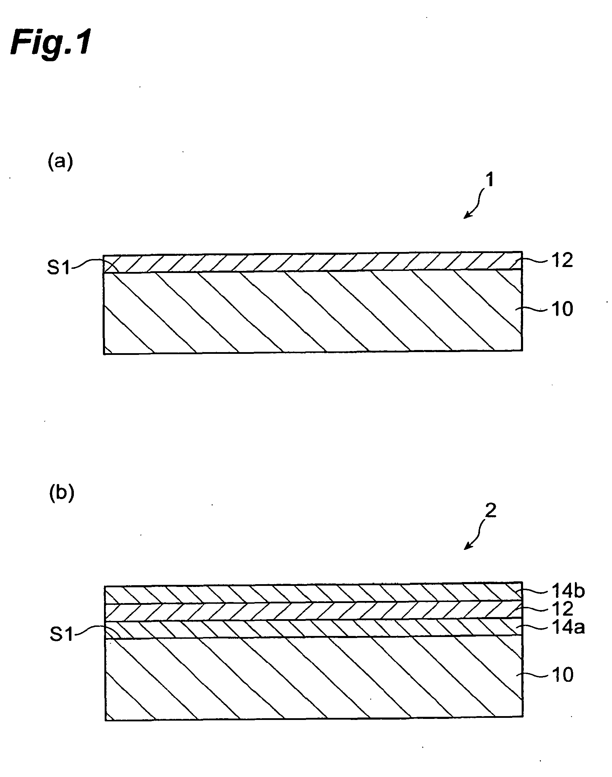

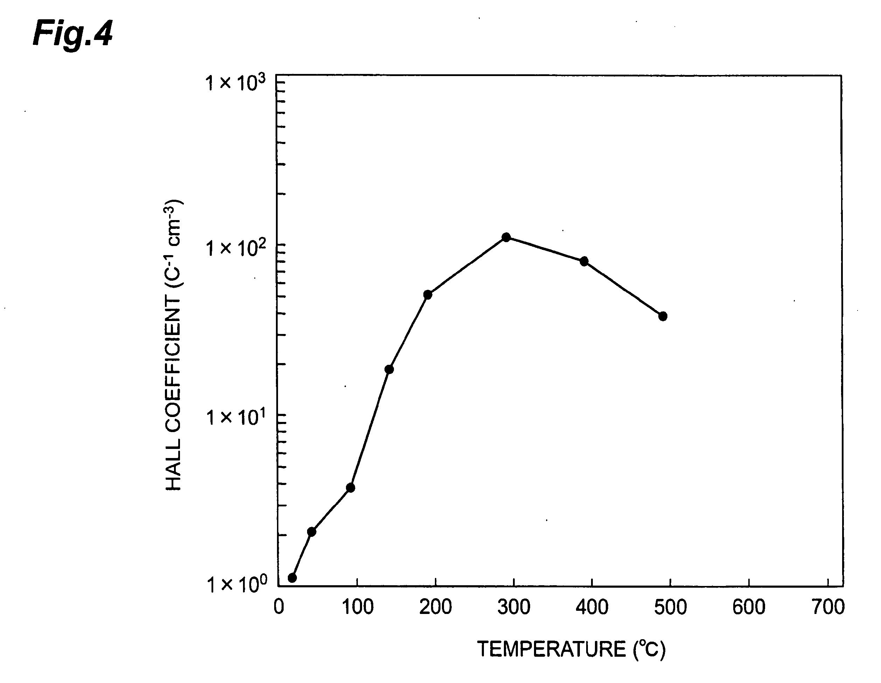

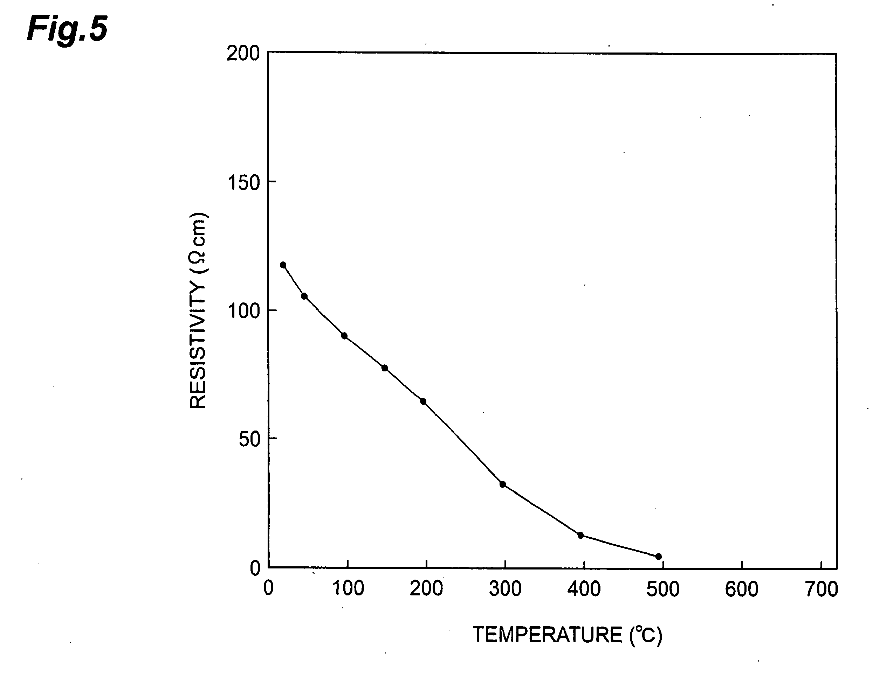

In the following, embodiments of the diamond n-type semiconductor, method of manufacturing the same, semiconductor device, and electron emitting device according to the present invention will be explained in detail with reference to Figs. 1 to 9. In the explanation of the drawings, constituents identical to each other will be referred to with numerals identical to each other without repeating their overlapping descriptions. Ratios of dimensions in the drawings do not always coincide with those explained.

The area (a) shown in Fig. 1 is a sectional view showing the structure of a first embodiment of the diamond n-type semiconductor according to the present invention. The diamond n-type semiconductor 1 according to the first embodiment comprises a diamond substrate 10 and a first diamond semiconductor layer 12. Monocrystal diamond is used as the diamond substrate 10. Though a heteroepitaxial substrate or highly-oriented polycrystal film is also usable as the diamond substrate 10, monocrystal diamond is more preferably used. The first diamond semiconductor layer 12 is formed on a main surface S1 of the diamond substrate 10. The first diamond semiconductor layer 12 is preferably formed by plasma CVD of microwaves in an apparatus having optimized its dopant gas introduction, because of its favorable donor concentration controllability. Other forming methods may also be used, however. Here, P (phosphorus) or S (sulfur) is used as the donor element, for example. Though hydrides such as phosphine (PH₃) and hydrogen sulfide (H₂S) are favorably usable as a material for the donor element, organic compounds containing alkoxides, halides, oxides, and the like are also be usable. The surface orientation of the main surface S 1 is preferably {111} and {100} when the donor element is P and S, respectively. A {111} surface may finely be formed on a {100} substrate by an appropriate processing technique, so as to yield the main surface S 1 with a surface orientation of {111}.

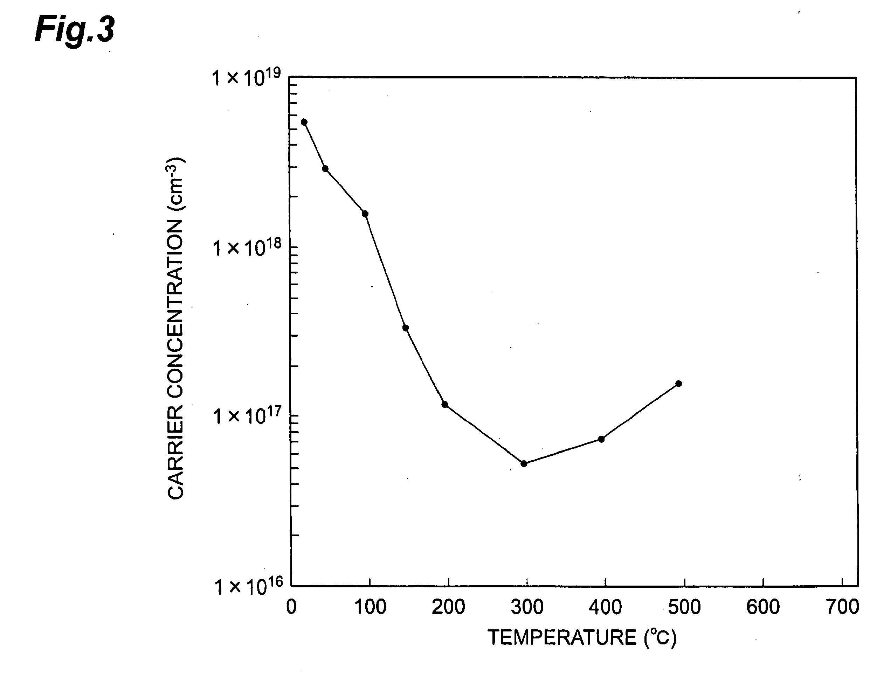

The first diamond semiconductor layer 12 is detected as n-type by an appropriate semiconductor evaluating apparatus or measuring apparatus, whereas its carrier concentration (electron concentration) is negatively correlated with temperature while the Hall coefficient of a conductor is positively correlated with temperature in a part of the temperature region where the n-type is detected. The temperature region exhibiting such correlations exists at least within the temperature region from 0°C to 300°C, preferably over a temperature range of at least 100°C, more preferably over a temperature range of at least 200°C. By way of example, Fig. 3 shows a case where the above-mentioned correlations appear in the temperature range from 100°C to 300°C. At temperatures higher than the temperature region mentioned above, it will be preferred if the above-mentioned correlations are positive and negative for the carrier concentration and Hall coefficient, respectively. In Fig. 3, for example, the carrier concentration decreases as temperature increases from room temperature to 300°C, but increases as temperature increases at higher temperatures. Here, the room temperature is 25°C.

When forming the first diamond semiconductor layer 12, doping with a large amount of the donor elements is effected. For example, it will be preferred if the first diamond semiconductor layer 12 contains at least 5 x 10¹⁹ cm⁻³ in total of at least one kind of donor element. Preferably, at least P is contained as the donor element. At least S may be contained as the donor element as well. For doping with a large amount of the donor element, it will be preferred if a greater amount of the donor element is caused to reach a substrate by optimizing the doping gas introduction, e.g., by supplying a doping gas into a chamber from a gas inlet provided at a substrate support table such that the position for introducing the doping gas into the chamber is placed very close to the substrate, keeping the piping cooler than a temperature where the doping gas decomposes, and so forth. For doping with a large amount of the donor element, it will be preferred if the methane concentration in the above-mentioned microwave plasma CVD is very low. Namely, the methane concentration is preferably 0.08% or less, more preferably 0.03% or less. When the methane concentration is so low that it is lower than 0.003%, on the other hand, the growth rate of diamond becomes too low to be practical in the film forming, whereby the methane concentration is preferably at least 0.003%.

For doping with a large amount of the donor element while restraining the crystallinity of diamond from deteriorating, it will be preferred if an impurity other than the donor element is introduced together with the donor element when forming the first diamond semiconductor layer 12. Such an impurity is introduced by a concentration lower than that of the donor element. Suitable as the impurity is Si, whose concentration is preferably at least 1 x 10¹⁷ cm⁻³. The effect of enabling very-high-concentration doping with the donor element appears at a P/C (ratio between the number of phosphorus atoms and the number of carbon atoms) of at least 5,000 ppm in a vapor phase when making a P-doped diamond semiconductor by vapor-phase growth. The impurity may be Al as well. Doping with the donor element may be effected while artificially causing a distortion or point defect in a diamond crystal instead of or together with introducing such an impurity.

The carrier concentration in the first diamond semiconductor layer is preferably always at least 10¹⁶ cm⁻³, more preferably at least 5 x 10¹⁶ cm⁻³, in the temperature region from 0°C to 300°C. The resistivity of the first diamond semiconductor layer 12 is preferably 500 Ωcm or less at least at a temperature within the temperature region from 0°C to 300°C.

The effect of the diamond n-type semiconductor 1 according to the first embodiment will now be explained.

In the diamond n-type semiconductor 1 according to the first embodiment, there is a temperature region in which the carrier concentration is negatively correlated with temperature while the Hall coefficient of a conductor is positively correlated with temperature. Consequently, the amount of change in carrier concentration in a wide temperature range is smaller than that in the conventional diamond n-type semiconductors whose carrier concentration is always positively correlated with temperature while the Hall coefficient is always negatively correlated with temperature. Specifically, the amount of change in carrier concentration in the temperature range from 0°C to 500°C is less than 3 digits, more preferably less than 1 digit. Similar phenomena can be understood also when a plurality of carriers having different degrees of mobility are taken into consideration. This is because a phenomenon of one carrier decreasing and a phenomenon of the other carrier increasing are superposed on each other. Therefore, the diamond n-type semiconductor 1 is widely applicable to various semiconductor devices and electron emitting devices.

When a multilayer structure is formed by the first diamond semiconductor 12 and an n-type layer having a donor element concentration lower than that of the first diamond semiconductor 12, a strong carrier leaking effect from the first diamond semiconductor 12 to the n-type layer is obtained.

When the above-mentioned temperature range exists over at least 100°C within the temperature region from 0°C to 300°C, the amount of change in carrier concentration becomes sufficiently small in a wide temperature range. When the above-mentioned temperature range exists over at least 200°C, the amount of change in carrier concentration becomes further smaller in a wide temperature range. The carrier concentration negatively correlated with temperature and the Hall coefficient positively correlated with temperature appearing within the temperature region from 0°C to 300°C are very useful when applying the diamond n-type semiconductor 1. This is because the above-mentioned temperature range is typically included in temperatures at which the semiconductor devices and electron emitting devices are used.

When the diamond n-type semiconductor 1 having a resistivity of 500 Ωcm or less at least at a temperature within the temperature region from 0°C to 300°C is employed in a semiconductor device or electron emitting device, its contact resistance to an electrode metal which supplies a current to the device becomes smaller.

When the diamond n-type semiconductor 1 whose carrier concentration is always at least 10¹⁶ cm⁻³ in the above-mentioned temperature region is employed in an electron emitting device, its bias applying effect becomes remarkable, thereby yielding a favorable electron emitting property.

When the first semiconductor layer 12 contains more than 5 x 10¹⁹ cm⁻³ of at least one kind of donor element such as P or S element, for example, the diamond n-type semiconductor 1 having a sufficiently high carrier concentration is obtained.

When the first diamond semiconductor layer 12 is formed while introducing an impurity element other than the donor element together with the donor element, the diamond n-type semiconductor doped with a large amount of the donor element can be obtained while preventing the crystallinity of diamond from deteriorating greatly. Here, it will be preferred if the first diamond semiconductor layer 12 contains Si as the impurity element by a concentration of at least 1 x 10¹⁷ cm⁻³. In this case, the above-mentioned effect of enabling very-high-concentration doping with the donor element while keeping the crystallinity of diamond from deteriorating is exhibited further remarkably. This effect appears at a P/C (ratio between the number of phosphorus atoms and the number of carbon atoms) of at least 5,000 ppm in a vapor phase when making a P-doped diamond semiconductor by vapor-phase growth.

The area (b) shown in Fig. 1 is a sectional view showing the structure of a second embodiment of the diamond n-type semiconductor according to the present invention. The diamond n-type semiconductor 2 according to the second embodiment comprises a diamond substrate 10, a first diamond semiconductor layer 12, and second semiconductor layers 14a, 14b. On a main surface S 1 of the diamond substrate 10, the second diamond semiconductor layer 14a, first diamond semiconductor layer 12, and second diamond semiconductor layer 14b are successively formed. These layers can be formed by epitaxial growth while utilizing a microwave plasma CVD apparatus with an optimized method of introducing a dopant gas for the first diamond semiconductor layer 12 and even a normal microwave plasma CVD apparatus for the second diamond semiconductor layers 14a, 14b. The diamond substrate 10 and first diamond semiconductor layer 12 are as explained in connection with the first embodiment shown in the area (a) of Fig. 1. In the second semiconductor layers 14a, 14b turned out to be n-type as with the first diamond semiconductor layer 12, on the other hand, the Hall coefficient of a conductor is not positively correlated with temperature while the carrier concentration is negatively correlated with temperature. Namely, the carrier concentration of the second diamond semiconductor layers 14a, 14b is always positively correlated with temperature or a fixed value regardless of temperature. Here, the second diamond semiconductor layers 14a, 14b are named so for convenience of distinguishing them from the first diamond semiconductor layer 12.

In the diamond n-type semiconductor 2 according to the second embodiment, carriers leak from the first diamond semiconductor layer 12 into the second diamond semiconductor layers 14a, 14b adjacent to the first diamond semiconductor layer 12. Therefore, the carrier concentration of the diamond n-type semiconductor 2 as a whole increases. Here, the carrier leaking effect is particularly high, since the carrier concentration of the first diamond semiconductor layer 12 is negatively correlated with temperature as mentioned above.

One of the second diamond semiconductor layers 14a, 14b may be provided alone in the second embodiment. Namely, though both sides of the first diamond semiconductor layer 12 are covered with the second diamond semiconductor layers 14a, 14b in the diamond n-type semiconductor 2 according to the second embodiment shown in the area (b) of Fig. 1, only one side of the first diamond semiconductor layer 12 may be covered with the second diamond semiconductor layer 14a or 14b. Though the second diamond semiconductor layers 14a, 14b are provided so as to cover substantially all the areas of the faces of the first diamond semiconductor layer 12 in the diamond n-type semiconductor 2 according to the second embodiment shown in the area (b) of Fig. 1, the second diamond semiconductor layer 14a and/or 14b may be provided so as to cover only a part of the faces of the first diamond semiconductor layer 12. In any case, the second diamond semiconductor layer 14a, 14b is provided adjacent to at least a part of the first diamond semiconductor layer 12, thus yielding the effect of increasing the carrier concentration of the diamond n-type semiconductor 2 according to the second embodiment as a whole because of the carrier leaking mentioned above. Though only one layer of first diamond semiconductor 12 is provided in the diamond n-type semiconductor 2 according to the second embodiment shown in the area (b) of Fig. 1, a plurality of semiconductor layers similar to the first diamond semiconductor layer 12 may be provided so as to be stacked alternately with a plurality of second diamond semiconductor layers as a matter of course.

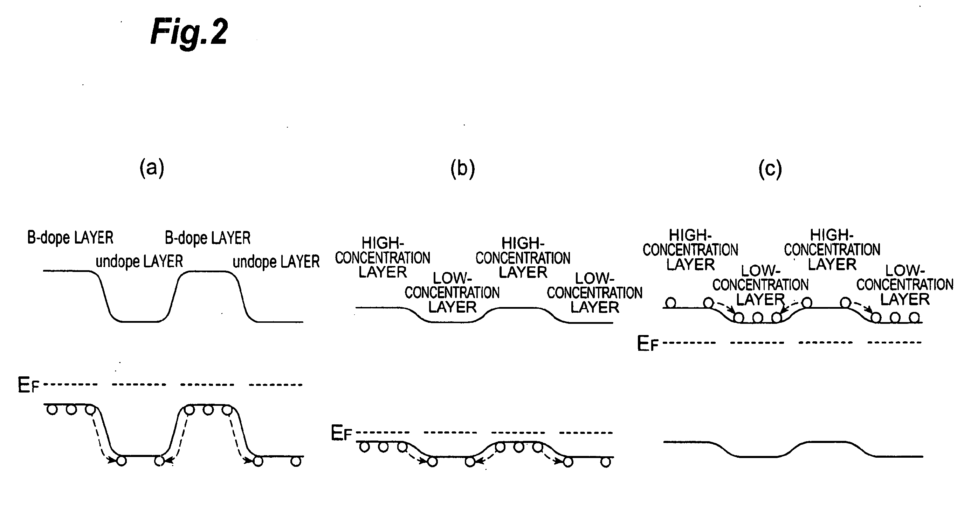

The fact that the carrier leaking effect is particularly strong in the diamond n-type semiconductor 2 according to the second embodiment will now be explained in more detail with reference to Fig. 2. In Fig. 2, the area (c) is a diagram concerning the diamond n-type semiconductor according to the second embodiment, whereas the areas (a) and (b) are diagrams concerning its comparative examples. The area (a) shown in Fig. 2 is an energy band obtained when a boron-doped layer (B-dope layer) and an undoped layer (undope layer) are stacked. In such a structure in which doped and undoped layers are stacked, carriers leak from the doped layer into the undoped layer by diffusion in general as indicated by arrows in the drawing. Since a potential barrier is generated, however, a force acts to pull back the carriers from the undoped layer to the doped layer. Therefore, an entropic force caused by the diffusion and a potential force caused by a fixed charge compete with each other, thereby reducing the leaking force.

The area (b) shown in Fig. 2 is an energy band obtained when a high-concentration boron-doped layer and a low-concentration boron-doped layer are stacked. In this case, as compared with the energy band shown in the area (a) of Fig. 2, the carrier pullback force becomes smaller, since the potential barrier is lower. However, a force competing against the carrier leaking acts anyway, thereby reducing the leaking force. In the case of boron, doping with a large amount makes the carrier concentration independent of temperature, i.e., constant regardless of temperature changes. Also, the effective bandgap becomes smaller, thereby making it harder to implant carriers into intrinsic semiconductors.

On the other hand, the area (c) of Fig. 2 is an energy band obtained when a high-concentration phosphorus-doped layer (e.g., the first diamond semiconductor layer 12 in the second embodiment) and a low-concentration phosphorus-doped layer (e.g., the second diamond semiconductor layer 14a, 14b in the second embodiment) are stacked. In this case, the bandgap of the high-concentration phosphorus-doped layer is not made smaller, so that no potential barrier substantially occurs between the high-concentration phosphorus-doped layer and low-concentration phosphorus-doped layer. The carrier leaking effect into the low-concentration phosphorus-doped layer rather increases as the Fermi level (E_{F}) decreases. This is one of advantages of the carrier concentration negatively correlated with temperature. The above-mentioned effect is easier to exhibit as the multilayer structure is thinner.

Each of the diamond n-type semiconductors 1, 2 according to the first and second embodiments respectively shown in the areas (a) and (b) of Fig. 1 is favorably applicable to semiconductor devices such as SCR, GTO, SIT, IGBT, and MISFET. When the diamond n-type semiconductors 1, 2 are employed for a part or all of n-type layers in these devices, for example, the devices can favorably operate in a wide temperature range. When the diamond n-type semiconductors 1, 2 are employed in a contact part with respect to electrode metals, favorable ohmic contact is obtained in particular. When a pn junction is formed between the diamond n-type semiconductor and a diamond p-type semiconductor, a semiconductor device such as pn diode can be formed.

The diamond n-type semiconductors 1, 2 are also favorably employed in electron emitting devices used in displays, electron guns, fluorescent tubes, and vacuum tubes. Electron emitting devices employing the diamond n-type semiconductors 1, 2 in electron emitting parts can operate favorably in a wide temperature range, while having a high electron emitting property. An electron emitting device may also be constructed such that a target plate for receiving electrons is charged positive while the diamond n-type semiconductor is charged negative.

### Specific Example 1

Specific examples of the diamond n-type semiconductor, method of manufacturing the same, semiconductor, and electron emitting device according to the present invention will now be explained.

On a 2-mm square monocrystal diamond IIa {111} substrate, phosphorus-doped diamond was epitaxially grown under the following condition with a microwave plasma CVD apparatus having optimized its dopant gas introduction. The growing condition was such that the methane concentration (CH₄/H₂) = 0.003% to 1.0%, the phosphine concentration (PH₃/CH₄) = 1,000 ppm to 200,000 ppm, the power was 200 W to 400 W, the substrate temperature was 850°C to 1,000°C, and the pressure was 100 Torr (1.33 x 10⁴ Pa). Further, a CO₂ gas was added such that (CO₂/CH₄) = 0.1% to 10%. This was done in order to make the P take-up better than that in the case without CO₂, though films will not be formed if CO₂ is added by the same level as with CH₄. As a consequence, an epitaxial film having a thickness of 1 to 2 µm was formed. Areas, each having a diameter of 200 µm, positioned at four corners of the epitaxial film formed on the substrate were implanted with Ar ions, whereby the epitaxial film was graphitized. Thereafter, a Ti/Pt/Au electrode was formed, whereby an ohmic electrode was obtained. A diamond n-type semiconductor was manufactured by the foregoing steps.

Though a plurality of diamond n-type semiconductors were manufactured under various synthesizing conditions in Specific Example 1 mentioned above, they are not always included in diamond n-type semiconductors according to the present invention. Only those in which the carrier concentration is negatively correlated with temperature in a temperature range of at least 100°C within the temperature region from 0°C to 300°C while the Hall coefficient of a conductor is positively correlated with temperature are included in the diamond n-type semiconductors according to the present invention as will be explained later. Thus, those without the correlations mentioned above are comparative examples for the diamond n-type semiconductors included in the present invention.

Hall effect measurement utilizing an AC magnetic field evaluated n-type determination, resistivity, carrier concentration, Hall coefficient, mobility, and the like. Figs. 3, 4, and 5 show results obtained by the Hall effect measurement concerning the carrier concentration, Hall effect, and resistivity in a typical sample (CH₄/H₂ = 0.05%, PH₃/CH₄ = 22,000 ppm) within the temperature range from 0°C to 500°C, respectively. The measured sample was turned out to be n-type at 100°C or higher, and the carrier concentration was negatively correlated with temperature while the Hall coefficient of a conductor was positively correlated with temperature in the temperature region from 100°C to 300°C.

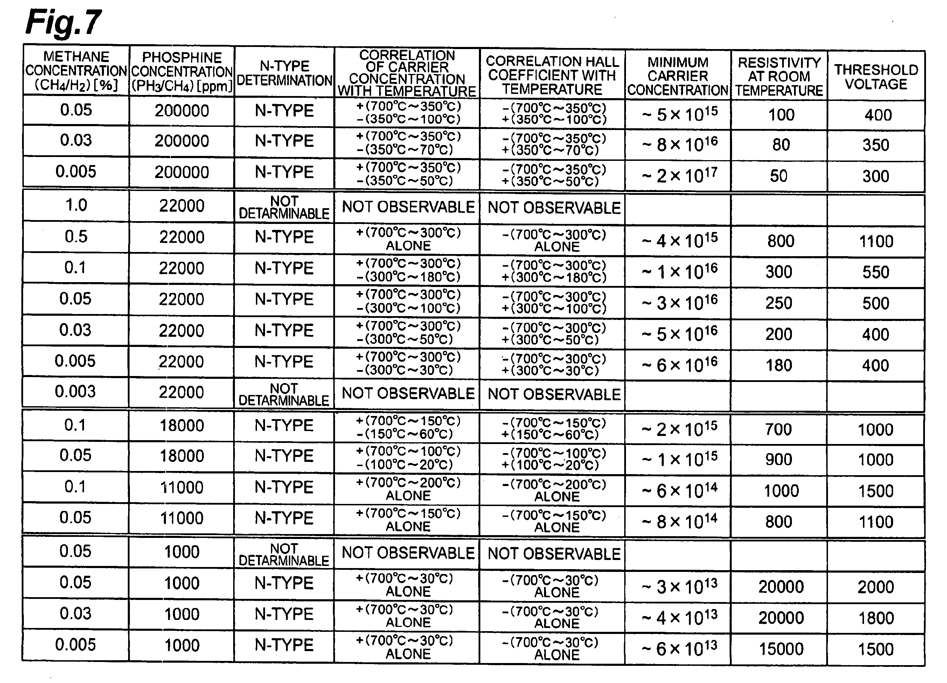

Fig. 7 is a table concerning a plurality of samples manufactured as diamond n-type semiconductors according to the present invention, showing conditions under which they were synthesized, conditions under which their phosphorus-doped layers were synthesized, and measurement results of the Hall effect.

The columns of "Correlation of carrier concentration with temperature" and "Correlation of Hall coefficient with temperature" in the table of Fig. 7 will now be explained. For the uppermost sample (CH₄/H₂ = 0.05%, PH₃/CH₄ = 200,000 ppm), for example, the above-mentioned columns indicate that the carrier concentration and Hall coefficient were positively and negatively correlated with temperature, respectively, in the temperature range of 700°C to 350°C, and that they were negatively and positively correlated with temperature in the temperature range of 350°C to 100°C. The column of "N-type determination" notes "n-type" when samples were turned out to be n-type in the temperature ranges listed in the columns of "Correlation of carrier concentration with temperature" and "Correlation of Hall coefficient with temperature". As can be seen from Fig. 7, samples under specific methane concentration conditions (CH₄/H₂ = 0.05% to 0.005%) with a high phosphine concentration (PH₃/CH₄ = 200,000 ppm) exhibited the carrier concentration negatively correlated with temperature in a temperature range of at least 100°C within the temperature region from 0°C to 300°C and the Hall coefficient positively correlated with temperature. Also, samples under methane concentration conditions of CH₄/H₂ = 0.005% to 0.1% with a phosphine concentration of 22,000 ppm exhibited the carrier concentration negatively correlated with temperature in a temperature range of at least 100°C within the temperature region from 0°C to 300°C and the Hall coefficient positively correlated with temperature.

The minimum carrier concentration turned out to be at least 1 x 10¹⁶ cm⁻³ in any of the samples whose carrier concentration was negatively correlated with temperature in a temperature range of at least 100°C within the temperature region from 0°C to 300°C. This is related to the fact that the carrier concentration tends to increase as the temperature decreases in a temperature region lower than a certain temperature, and thus does not become lower than a fixed amount (i.e., the carrier concentration at a boundary temperature between positive and negative correlations). While the sample in which CH₄/H₂ = 0.1% and PH₃/CH₄ = 22,000 ppm yielded the highest resistivity of 300 Ωcm among the samples exhibiting the negative correlation, the other samples exhibited the carrier concentration negatively correlated with temperature in a temperature range of at least 200°C within the temperature region from 0°C to 300°C.

The P atom concentrations determined by SIMS were 8.5 x 10¹⁹ to 1.1 x 10²⁰/cm³ at 200,000 ppm, 5.1 x 10¹⁹ to 8.3 x 10¹⁹/cm³ at 22,000 ppm, 4.0 x 10¹⁹ to 4.9 x 10¹⁹/cm³ at 18,000 ppm, 1.9 x 10¹⁹ to 3.7 x 10¹⁹/cm³ at 11,000 ppm, and 6.1 x 10¹⁸ to 8.8 x 10¹⁸/cm³ at 1,000 ppm. On the other hand, the Si atom concentration was determined and found to be not greater than the detection limit (7 x 10¹⁶/cm³) in all the samples.

A semiconductor device manufactured in the following manner using the above-mentioned diamond n-type semiconductor will now be mentioned. Specifically, a pn junction was formed between a layer of n-type exhibiting a carrier concentration negatively correlated with temperature in a temperature range of at least 100°C within the temperature region from 0°C to 300°C and a p-type diamond layer, so as to yield a pn diode, while a junction was formed between a layer exhibiting a carrier concentration negatively correlated with temperature in a temperature range of less than 100°C within the temperature region from 0°C to 300°C or a layer exhibiting a carrier concentration only positively correlated with temperature without negative correlation and a p-type diamond layer, so as to yield a pn diode. When their properties were compared with each other, there was a remarkable difference between their temperature dependencies. Namely, while the rectification ratio and forward resistance of the latter pn diode changed by 3 digits or more in the temperature range from 0°C to 500°C, the former pn diode changed by only 1 to less than 3 digits. In particular, they changed by only 1 to 2 digits in layers whose carrier concentration was negatively correlated with temperature in a temperature range of at least 200°C within the temperature region from 0°C to 300°C. For realizing a property with a smaller amount of change in a wider temperature range, the temperature control for devices was much easier when a semiconductor device was made by using a diamond n-type semiconductor whose carrier concentration was negatively correlated with temperature in a temperature range of at least 100°C within the temperature region from 0°C to 300°C than when using a diamond n-type semiconductor whose carrier concentration was negatively correlated with temperature in a temperature range of less than 100°C within the temperature region from 0°C to 300°C or only positively correlated with temperature.

An electron emitting device manufactured by using a diamond n-type semiconductor whose carrier concentration was negatively correlated with temperature in a temperature range of at least 100°C within the temperature region from 0°C to 300°C as an electron emitter (electron emitting part) and an electron emitting device manufactured by using a diamond n-type semiconductor whose carrier concentration was negatively correlated with temperature in a temperature range of less than 100°C within the temperature region from 0°C to 300°C or only positively correlated with temperature as an electron emitter (electron emitting part) will now be mentioned. Here, the electron emitter was subjected to a sharpening process. The following are results of comparison between these electron emitting devices. The distance between the electron emitter and anode was 100 µm. When their threshold voltages (electron emission start voltages) and maximum emission current values were compared, the electron emitting device using the diamond n-type semiconductor whose carrier concentration was negatively correlated with temperature in a temperature range of at least 100°C within the temperature region from 0°C to 300°C yielded a lower threshold voltage of 550 V or less and a higher maximum emission current value. When the carrier concentration was negatively correlated with temperature in a temperature range of at least 200°C within the temperature region from 0°C to 300°C in particular, the threshold voltage was as low as 500 V or less. The column of "Threshold voltage" in Fig. 7 lists the results of measurement of threshold voltages concerning the samples manufactured as the diamond n-type semiconductors according to the present invention.

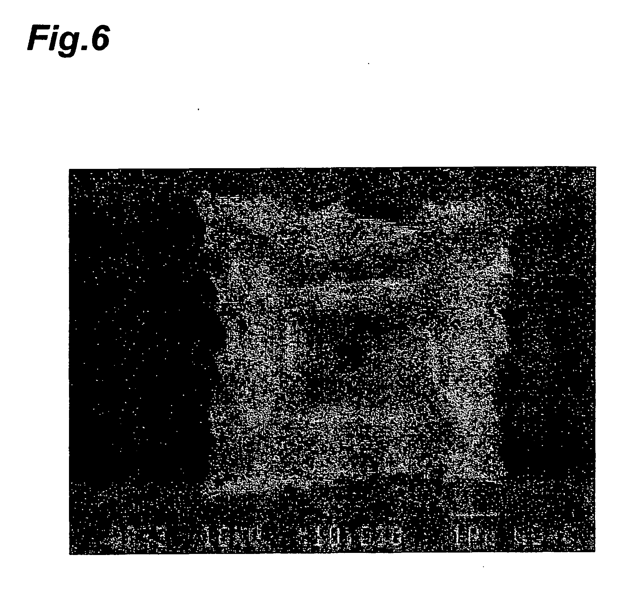

An electron emitting device obtained by growing in a vapor phase a diamond n-type semiconductor whose carrier concentration was negatively correlated with temperature in a temperature range of at least 100°C within the temperature region from 0°C to 300°C on a diamond {100} monocrystal substrate having a main surface formed with a plurality of minute protrusions and an electron emitting device obtained by growing in a vapor phase a diamond n-type semiconductor whose carrier concentration was negatively correlated with temperature in a temperature range of less than 100°C within the temperature region from 0°C to 300°C or only positively correlated with temperature on the diamond {100} monocrystal substrate will now be mentioned. Fig. 6 is a photograph of an electron emitting part in the electron emitting device using the diamond n-type semiconductor whose carrier concentration was negatively correlated with temperature in a temperature range of at least 100°C within the temperature region from 0°C to 300°C. This electron emitting part was arranged such as to be symmetrical about a center axis of the electron emitting device seen in a vertical direction when rotated by increments of 90 degrees. This symmetry will be referred to as "quarter rotation symmetry". This can form the electron emitting device regularly, thereby preventing it from abutting against its adjacent electron emitting parts.

This electron emitting device further comprised four continuous {111} small planes and a {100} small plane disposed at the center and leading ends of the small planes. All the electron emitting parts other than the one shown in Fig. 6 also had the form shown in Fig. 6. Here, it will be preferred if the electron emitting part has a quarter rotation symmetry about a center axis which is preferably inclined by 35 degrees or less from the vertical direction when the electron emitting device is seen in the vertical direction. This is because, when a side wall face of a pyramid-shaped electron emitting device forms the minimum angle of 55 degrees with its bottom face, the limit angle at which the side wall face does not become vertical by tilting the protrusions is 35 degrees. It will further be preferred if the electron emitting part has a quarter rotation symmetry about a center axis which is inclined by 10 degrees or less from the vertical direction when the electron emitting device is seen in the vertical direction. This can form the electron emitting device more regularly and can more reliably prevent it from abutting against protrusions of its adjacent electron emitting devices.

When the diamond semiconductor contains P as a donor element, the electron concentration negatively correlated with temperature and the Hall coefficient positively correlated with temperature can easily be obtained on the above-mentioned {111} surfaces in a temperature range of at least 100°C within the temperature region from 0°C to 300°C in the case of vapor-phase growth. Consequently, the electron emitting device having this electron emitting part favorably operates over a wide temperature range, thereby yielding a high electron emitting property.

### Specific Example 2

In a method similar to that of Specific Example 1 mentioned above, Specific Example 2 yielded a diamond n-type semiconductor by synthesizing a phosphorus-doped layer doped with not only P but also Si as 50 ppm of an SiH₄ gas (SiH₄/CH₄). Separately, Specific Example 2 also yielded a diamond n-type semiconductor by synthesizing a phosphorus-doped layer while trying to mix Si therein by placing a solid supply source for Si (Si semiconductor substrate) near a diamond substrate. Unlike Specific Example 1, Specific Example 2 did not add a CO₂ gas.

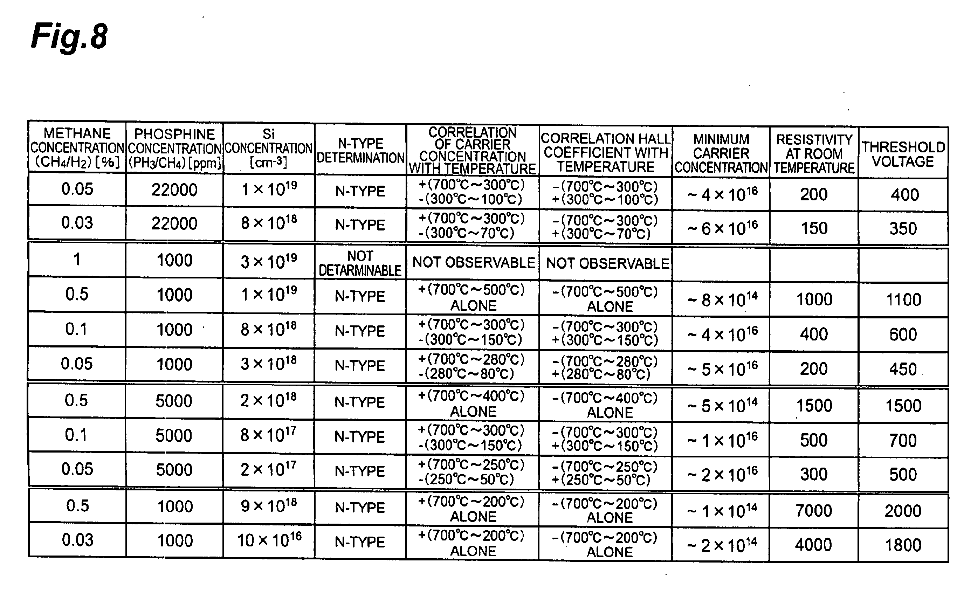

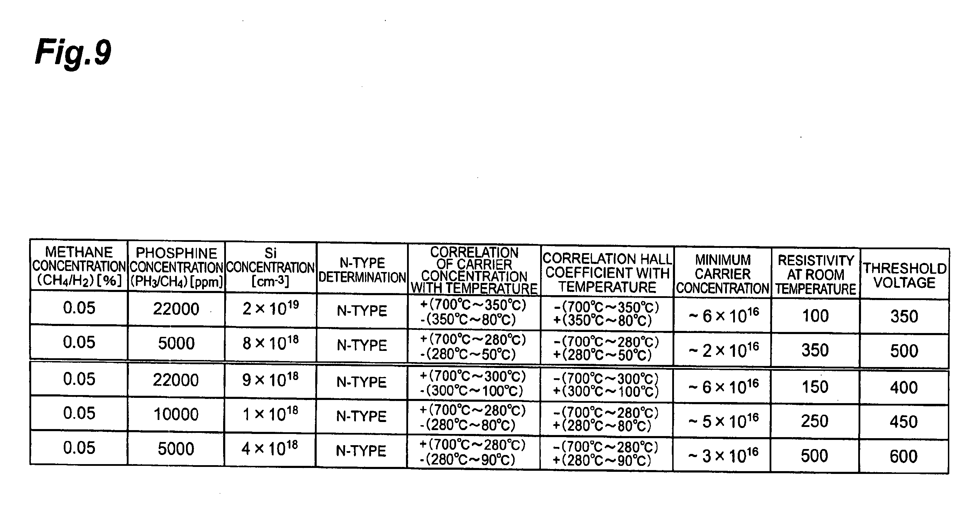

Fig. 8 is a table showing conditions under which phosphorus-doped layers (diamond semiconductor layers) were synthesized when Si was supplied by a gas, Si atom concentrations in SIMS results, and measurement results of Hall effect in a plurality of samples (diamond n-type semiconductors) manufactured. Fig. 9 is a table showing conditions under which phosphorus-doped layers were synthesized when Si was supplied by a solid, Si atom concentrations in SIMS results, and measurement results of Hall effect in a plurality of samples (diamond n-type semiconductors) manufactured. In Fig. 9, two samples in the upper part are those in which SiO₂ was supplied as a solid. Three samples in the lower part are those in which Si was supplied as a solid.

As can be seen from the results of Fig. 8, the range of sample forming conditions under which the characteristic of the carrier concentration negatively correlated with temperature in a temperature range of at least 100°C and the Hall coefficient positively correlated with temperature was exhibited within the temperature region from 0°C to 300°C became broader when Si was mixed by an atom concentration of 1 x 10¹⁷/cm³ or more. Namely, though only the samples having a phosphine concentration of 22,000 ppm or greater exhibited the characteristic of the above-mentioned correlations in Specific Example 1 mentioned above (see Fig. 7), samples having a phosphine concentration of 20,000 ppm or less (10,000 ppm and 5,000 ppm in Fig. 8) also exhibited the above-mentioned characteristic in Specific Example 2 as shown in Fig. 8.

Among the samples having such correlations, those exhibiting the highest resistivity were a sample doped with the SiH₄ gas (CH₄/H₂ = 0.1%, PH₃/CH₄ = 5,000 ppm) and a sample fed with Si by a solid (CH₄/H₂ = 0.05%, PH₃/CH₄ = 5,000 ppm), each yielding 500 Ωcm. The sample exhibiting the second-highest resistivity was one doped with the SiH₄ gas (CH₄/H₂ = 0.1%, PH₃/CH₄ = 10,000 ppm) yielding 400 Ωcm. Diodes and electron emitting devices using the diamond n-type semiconductors under these conditions attained the effect that the amount of change in characteristics of these devices was small with respect to temperature as in Specific Example 1. Samples other than those mentioned above yielded the carrier concentration negatively correlated with temperature in a temperature range of at least 200°C within the temperature region from 0°C to 300°C. As in Specific Example 1, the column of "Threshold voltage" in Fig. 8 lists threshold voltages which were measurement results of electron emitting property. The case where the carrier concentration was negatively correlated with temperature in a temperature range of at least 100°C within the temperature region from 0°C to 300°C yielded a lower threshold voltage of 700 V or less and a higher maximum emission current value. When the carrier concentration was negatively correlated with temperature in a temperature range of at least 200°C within the temperature region from 0°C to 300°C in particular, the threshold voltage was as low as 500 V or less.

The P atom concentrations as the SIMS results were 9.0 x 10¹⁹ to 1.3 x 10²⁰/cm³, 7.3 x 10¹⁹ to 8.8 x 10¹⁹/cm³, 5.1 x 10¹⁹ to 6.5 x 10¹⁹/cm³, and 9.1 x 10¹⁸ to 2.2 x 10¹⁹/cm³ at the phosphine concentrations of 22,000 ppm, 10,000 ppm, 5,000 ppm, and 1,000 ppm, respectively.

As can be seen from Fig. 9, results with a tendency similar to those shown in Fig. 8 were obtained also when Si and SiO₂ were supplied as solids. Though efficiency and controllability were inferior to those in doping with gases, doping with solids were possible.

On a 2-mm square monocrystal diamond IIa {100} substrate, sulfur-doped diamond was epitaxially grown under the following condition with a microwave plasma CVD apparatus having optimized its dopant gas introduction. The growing condition was such that the methane concentration (CH₄/H₂) = 0.03% to 2.0%, the hydrogen sulfide concentration (H₂S/H₂) = 20,000 ppm to 2,000,000 ppm, the power was 200 W to 400 W, the substrate temperature was 850°C to 1,000°C, and the pressure was 100 Torr (1.33 x 10⁴ Pa). This formed an epitaxial film having a thickness of 1 to 2 µm. When evaluated as in Specific Example 1, all the samples manufactured under the conditions mentioned above were turned out to be n-type in at least the temperature range from 100°C to 300°C, and exhibited a carrier concentration negatively correlated with temperature, a Hall coefficient of a conductor positively correlated with temperature, a resistivity of 480 Ωcm or less, and an electron concentration of 1.3 x 10¹⁶ cm⁻³ or greater. The S atom concentration determined by SIMS was 6.0 x 10¹⁹/cm³ or greater in all the samples manufactured. When temperature dependencies of rectification ratio and forward resistance were determined in pn diodes manufactured as in Specific Example 1, they changed by only 1 to 2 digits in all the samples. The threshold voltage determined in electron emitting devices manufactured as in Specific Example 1 was as low as 700 V or less in all the samples.

As can be seen from the foregoing specific examples, the diamond n-type semiconductor according to the present invention exhibits a smaller amount of change in carrier concentration in a wide temperature range, and thus can yield a device exhibiting a smaller amount of change in device characteristics with respect to temperature when employed in a semiconductor device such as diode or an electron emitting device. Therefore, the diamond n-type semiconductor according to the present invention can publicly be employed in light-emitting devices, transistors, and the like.

From the invention thus described, it will be obvious that the embodiments of the invention may be varied in many ways.

### Industrial Applicability

The present invention is applicable to semiconductor devices such as SCR, GTO, SIT, IGBT, and MISFET, and electron emitting devices partly constituting displays, electron guns, fluorescent tubes, vacuum tubes, and the like.

## Claims

1. A diamond n-type semiconductor comprising a first diamond semiconductor having n-type conduction and in which a distortion or defect is artificially formed, wherein:
said first diamond semiconductor contains more than 5 x 10¹⁹ cm⁻³ in total of at least one kind of donor element;
said first diamond semiconductor contains an impurity element other than the donor element together with the donor element, the concentration of the impurity element being lower than the concentration of the donor element;
in said first diamond semiconductor, a conductor exhibits an electron concentration negatively correlated with temperature in a temperature range of at least 100°C within at least the temperature region from 0°C to 300°C;
said first diamond semiconductor contains at least P (phosphorus) as the donor element;
said first diamond semiconductor contains at least 1 x 10¹⁷ cm⁻³ of Si as the impurity element; and
the first diamond semiconductor is made by vapor phase growth and the ratio between the number of phosphorus atoms and the number of carbon atoms in the vapor phase is at least 5000 ppm.

2. A diamond n-type semiconductor according to claim 1, wherein, in said first diamond semiconductor, the conductor exhibits a Hall coefficient positively correlated with temperature in a temperature range of at least 100°C within at least the temperature region from 0°C to 300°C.

3. A diamond n-type semiconductor according to claim 1 or 2, wherein the temperature range exists over at least 200°C within the temperature region from 0°C to 300°C.

4. A diamond n-type semiconductor according to any one of claims 1 to 3, wherein said first diamond semiconductor has a resistivity of 500 Ωcm or less at least at a temperature within the temperature region from 0°C to 300°C.

5. A diamond n-type semiconductor according to any one of claims 1 to 4, wherein the electron concentration of said first diamond semiconductor is always at least 10¹⁶ cm⁻³ in the temperature region from 0°C to 300°C.

6. A diamond n-type semiconductor according to claim 1, wherein said first diamond semiconductor contains at least S (sulfur) as the donor element.

7. A diamond n-type semiconductor according to any one of claims 1 to 6, wherein said first diamond semiconductor is monocrystal diamond.

8. A diamond n-type semiconductor according to any one of claims 1 to 7, further comprising a second diamond semiconductor provided adjacent to said first diamond semiconductor and turned out to be n-type,
wherein, in said second diamond semiconductor, a conductor exhibits an electron concentration not negatively correlated with temperature and a Hall coefficient not positively correlated with temperature.

9. A semiconductor device at least partly employing a diamond n-type semiconductor according to any one of claims 1 to 8.

10. An electron emitting device having the diamond n-type semiconductor according to any one of claims 1 to 9 employed in at least an electron emitting part thereof.

11. A method of manufacturing a diamond n-type semiconductor according to any one of claims 1 to 8, said method comprising the steps of:
preparing a diamond substrate; and
epitaxially growing said first diamond semiconductor on said diamond substrate while artificially introducing an impurity element other than a donor element to said diamond substrate.

12. A method of manufacturing a diamond n-type semiconductor according to claim 11, wherein Si is artificially introduced as the impurity element to said diamond substrate.

## Patentansprüche

1. Diamanthalbleiter vom n-Typ umfassend einen ersten Diamanthalbleiter mit einer n-Leitung und in welchem eine Verzerrung oder ein Defekt künstlich gebildet ist, wobei:
der erste Diamanthalbleiter insgesamt mehr als 5 x 10¹⁹ cm⁻³ einer Art eines Donorelementes enthält;
der erste Diamanthalbleiter ein anderes Verunreinigungselement als das Donorelement zusammen mit dem Donorelement enthält, wobei die Konzentration des Verunreinigungselements niedriger ist als die Konzentration des Donorelementes;
wobei in dem ersten Diamanthalbleiter ein Leiter eine Elektronenkonzentration zeigt, die negativ mit der Temperatur in einem Temperaturbereich von wenigstens 100 °C wenigstens in der Temperaturregion von 0 °C bis 300 °C korreliert;
der erste Diamanthalbleiter wenigstens P (Phosphor) als ein Donorelement enthält;
der erste Diamanthalbleiter wenigstens 1 x 10¹⁷ cm⁻³ Si als das Verunreinigungselement enthält; und
der erste Diamanthalbleiter durch ein Gasphasenwachstum hergestellt ist und das Verhältnis zwischen der Anzahl der Phosphoratome und der Anzahl der Kohlenstoffatome in der Dampfphase wenigstens 5000 ppm beträgt.

2. Diamanthalbleiter vom n-Typ nach Anspruch 1, wobei der Leiter in dem ersten Diamanthalbleiter einen Hall-Koeffizienten zeigt, der positiv mit der Temperatur in einem Temperaturbereich von wenigstens 100 °C wenigstens in der Temperaturregion von 0 °C bis 300 °C korreliert.

3. Diamanthalbleiter vom n-Typ nach Anspruch 1 oder 2, wobei der Temperaturbereich über wenigstens 200 °C in der Temperaturregion von 0 °C bis 300 °C existiert.

4. Diamanthalbleiter vom n-Typ nach einem der Ansprüche 1 bis 3, wobei der erste Diamanthalbleiter einen Widerstand von 500 Ωcm oder weniger bei einer Temperatur innerhalb der Temperaturregion von 0 °C bis 300 °C aufweist.

5. Diamanthalbleiter vom n-Typ nach einem der Ansprüche 1 bis 4, wobei die Elektronenkonzentration des ersten Diamanthalbleiters immer wenigstens 10¹⁶ cm⁻³ in der Temperaturregion von 0 °C bis 300 °C beträgt.

6. Diamanthalbleiter vom n-Typ nach Anspruch 1, wobei der erste Diamanthalbleiter wenigstens S (Schwefel) als das Donorelement enthält.

7. Diamanthalbleiter vom n-Typ nach einem der Ansprüche 1 bis 6, wobei der erste Diamanthalbleiter monokristalliner Diamant ist.

8. Diamanthalbleiter vom n-Typ nach einem der Ansprüche 1 bis 7, des Weiteren umfassend einen zweiten Diamanthalbleiter bereitgestellt in der Nähe des ersten Diamanthalbleiters, und welcher n-Typ ist,
wobei ein Leiter in dem zweiten Diamanthalbleiter eine Elektronenkonzentration zeigt, die nicht negativ mit der Temperatur korreliert ist und einen Hall-Koeffizienten, der nicht positiv mit der Temperatur korreliert ist.

9. Halbleitereinrichtung, welche wenigstens teilweise einen Diamanthalbleiter vom n-Typ nach einem der Ansprüche 1 bis 8 einsetzt.

10. Elektronenemitierende Einrichtung mit einem Diamanthalbleiter n vom n-Typ ach einem der Ansprüche 1 bis 9, welcher in wenigstens einem elektronenemitierenden Teil eingesetzt ist.

11. Verfahren zur Herstellung eines Diamanthalbleiters vom n-Typ nach einem der Ansprüche 1 bis 8, wobei das Verfahren die Schritte umfasst:
Herstellen eines Diamantsubstrats; und
epitaxtisches Wachsen des ersten Diamanthalbleiters auf dem Diamantsubstrat, während künstlich ein anderes Verunreinigungselement als ein Donorelement in des Diamantsubstrat eingeführt wird.

12. Verfahren zur Herstellung eines Diamanthalbleiters vom n-Typ nach Anspruch 11, wobei Si künstlich als ein Verunreinigungselement dem Diamantsubstrat zugeführt wird.

## Revendications

1. Semi-conducteur de type n en diamant comprenant un premier semi-conducteur en diamant ayant une conduction de type n et dans lequel une déformation ou un défaut est artificiellement formé, où :
ledit premier semi-conducteur en diamant contient plus de 5 x 10¹⁹ cm⁻³ au total d'au moins un type d'élément donneur ;
ledit premier semi-conducteur en diamant contient un élément d'impureté autre que l'élément donneur conjointement avec l'élément donneur, la concentration de l'élément d'impureté étant inférieure à la concentration de l'élément donneur ;
dans ledit premier semi-conducteur en diamant, un conducteur présente une concentration d'électrons négativement corrélée à la température dans une plage de température d'au moins 100 °C dans au moins la région de température de 0 °C à 300 °C ;
ledit premier semi-conducteur en diamant contient au moins P (phosphore) en tant qu'élément donneur ;
ledit premier semi-conducteur en diamant contient au moins 1 x 10¹⁷ cm⁻³ de Si en tant qu'élément d'impureté ; et
le premier semi-conducteur en diamant est fabriqué par croissance en phase vapeur et le rapport entre le nombre d'atomes de phosphore et le nombre d'atomes de carbone dans la phase vapeur est d'au moins 5000 ppm.

2. Semi-conducteur de type n en diamant selon la revendication 1, dans lequel, dans ledit premier semi-conducteur en diamant, le conducteur présente un coefficient de Hall positivement corrélé à la température dans une plage de température d'au moins 100 °C dans au moins la région de température de 0 °C à 300 °C.

3. Semi-conducteur de type n en diamant selon la revendication 1 or 2, la plage de température étant située au-dessus d'au moins 200 °C dans la région de température de 0 °C à 300 °C.

4. Semi-conducteur de type n en diamant selon l'une quelconque des revendications 1 à 3, ledit premier semi-conducteur en diamant ayant une résistivité de 500 Ω.cm ou moins au moins à une température dans la région de température de 0 °C à 300 °C.

5. Semi-conducteur de type n en diamant selon l'une quelconque des revendications 1 à 4, la concentration d'électrons dudit premier semi-conducteur en diamant étant toujours d'au moins 10¹⁶ cm⁻³ dans la région de température de 0 °C à 300 °C.

6. Semi-conducteur de type n en diamant selon la revendication 1, ledit premier semi-conducteur en diamant contenant au moins S (soufre) en tant qu'élément donneur.

7. Semi-conducteur de type n en diamant selon l'une quelconque des revendications 1 à 6, ledit premier semi-conducteur en diamant étant un diamant monocristallin.

8. Semi-conducteur de type n en diamant selon l'une quelconque des revendications 1 à 7, comprenant en outre un deuxième semi-conducteur en diamant disposé en position adjacente audit premier semi-conducteur en diamant et configuré pour être de type n,
où, dans ledit deuxième semi-conducteur en diamant, un conducteur présente une concentration d'électrons non négativement corrélée à la température et un coefficient de Hall non positivement corrélé à la température.

9. Dispositif semi-conducteur utilisant au moins partiellement un semi-conducteur de type n en diamant selon l'une quelconque des revendications 1 à 8.

10. Dispositif émetteur d'électrons dans lequel le semi-conducteur de type n en diamant selon l'une quelconque des revendications 1 à 9 est utilisé dans au moins une partie émettrice d'électrons de celui-ci.

11. Procédé de fabrication d'un semi-conducteur de type n en diamant selon l'une quelconque des revendications 1 à 8, ledit procédé comprenant les étapes de :
préparation d'un substrat de diamant ; et
croissance épitaxiale dudit premier semi-conducteur en diamant sur ledit substrat de diamant en introduisant artificiellement un élément d'impureté autre qu'un élément donneur audit substrat de diamant.

12. Procédé de fabrication d'un semi-conducteur de type n en diamant selon la revendication 11, dans lequel Si est artificiellement introduit en tant qu'élément d'impureté sur ledit substrat de diamant.
